# EUROPEAN PATENT APPLICATION

(11) **EP 2 896 717 A1**
(43) Date of publication of application: **22.07.2015**
(21) Application number: 14151331.7
(22) Date of filing: 15.01.2014
(51) Int. Cl.: C23C 14/06, C23C 14/28

(54) **Laser direct synthesis and deposit of nanocomposite materials or nanostructures**

(71) Applicant: Nanotechplasma SARL, 1204 Genève (CH)
(72) Inventor: Serbezov, Valery, 4000 Plovdiv (BG)
(74) Representative: KATZAROV S.A.

(57) **Abstract**

The present invention relates to a method for laser assisted synthesis/formation of nanocomposite materials or nanostructures and contactless direct transfer/deposit thereof in one step and one technological cycle on to different types of receiving substrates.

## Description

### FIELD OF THE INVENTION

The present invention relates to a method for laser assisted synthesis/formation of nanocomposite materials or nanostructures and contactless direct transfer/deposit thereof in one step and one technological cycle on to different types of receiving substrates.

### BACKGROUND OF THE INVENTION

Laser transfer technologies are rapid prototyping techniques for deposition and controlled patterning of meso-, micro-, and nano- 2 dimensional (2D), 3- dimensional (3D) materials and receiving increasing attention in many industries. The existing laser rapid prototyping techniques are used for transfering and structuring different materials such as metals, dielectrics, semiconductors, alloys, organics, polymers, biopolymers, living cells or small mechanical or electronics structures or components. Several recent laser-based fabrication techniques make use of a mechanism of interaction on photons/laser with transferring material: Laser machining, Selective laser sintering, micro-laser sintering, Stereo lithography, Two-photon polymerization, Laser Direct Write (LDW). The LDW techniques are simple, flexible and cost effectiveness. Laser Induced Forward Transfer (LIFT) is a method of selective laser ablation of materials from a preliminary deposited thin film on a transparent carrier substrate - target and forward transferring the material onto a receiver substrate closely fixed to the target. LIFT is based on the LDW process where a focused laser beam is moving about the target and transfer the ablated material or article onto the receiver substrate. Other methods based on LIFT are Matrix-assisted pulsed laser evaporation direct-write (MAPLE DW); Absorbing film-assisted LIFT (AFA LIFT); Thermo-Mechanical Selective Laser Assisted Die Transfer (tmSLADT). The laser beam vaporizes the entire thin film in the region of laser focus at the classical LIFT. The LIFT methods typically use transformation of the energy of the photons/laser beam in the thermo-mechanical or shock wave energy by utilizing transparent donor layer for laser radiation and transferring additional contact layers, such as Dynamic Release Layer (DRL-LIFT), Laser Induced Thermal Imaging (LITI) or selectively absorbing light energy materials or specific selected photon energy, such as MAPLE DW, RIR MAPLE DW for targeted transfer of materials or structures onto a receiving substrate without damages and defragmentation especially for organics and biomaterials. The Ballistic Laser-Assisted Solid Transfer (BLAST) technique does not require a DRL and the main idea is to use several subsequent pulses with low energy (usual femtosecond (fs) laser) for transferring a donor material through a transparent support-donor layer. Its modification is also known as Laser Induced Solid Etching - LISE. These methods have multiple steps and consist of several technological processes for forming the layers of deposited metrials. They cannot directly synthesize and transfer nanostructures and nanocomposites.

One very important category of new materials which have to be transferred on predefined micro- or nano-areas and arrays on receiving substrates are nanocomposites and more exactly hybrid nanocomposites. The term nanocomposite is used to describe multiphase (multicomponent) one-, two- , three - dimensional or amorphous solid material produced of distinctly dissimilar components mixed at nanometre scale. The nanocomposites made of materials whose physical and/or chemical properties are very different are known as hybrid nanocomposites. One of the used phases of nanocomposite are nanoparticles that can be synthesized by laser ablation in vacuum, gas medium or in liquid medium from solid targets or from thin films. The nanocomposites are used in industries such as for example the medical field, biotechnology, sensors, microelectronics, photonics, in the energy sector, the automotive industry, or in aeronautical and aerospace. The nanocomposites changes the physical-chemical properties of a substrate. This includes, but is not limited to, a substrate's thermal, optical, magnetic and dielectric properties, its strength, electrical conductivity, etc. The LIFT processes are used for fabrication of nanocomposites,but one or more of the phases of the nanocomposite are added in advance/preliminary in the transferred layer (target). A disadvantage is thus that the process remains multi-steps with several technological cycles. It also requires the pre-production of one or more of nanocomposite phases. The LIFT processes are carried out in ambient conditions with use of focusing laser optics and CNC coordinate mechanism or laser scan device. The used lasers are in spectral range from UV to IR with pulse duration from ms, µs to ns, ps and fs. Currently in the development of 2D and 3D microstructures from metal nanoparticles and constructing metamaterials, applied LIFT techniques are producing controlled targeted nanoparticles from metals and multilayered nanofilms by tightly contacted donor-receiver pair through transparent donor substrate -target. Metal or multilayer thin films from metal, metal oxides, inorganic semiconductors are preliminary deposited onto transparent donor substrate by thermal evaporation or magnetron sputtering techniques on the back side of transparent donor-target. Another glass substrate acting as the receiver is tightly contacted with the donor substrate. A fs-laser is used as light/photon source. Drawbacks of these techniques include impossibility to transfer hybrid nanocomposite materials, nanostructurers or organic or hybrid nanoparticles.

For the above reasons, there is a need of an improved one step and one technological cycle method for rapid preparation of nanocomposite materials or nanostructures that does not suffer from the limitations of the prior art, that allows the possibility of depositing nanocomposite materials or nanostructures on determined micro- and nano- areas on receiving substrates, that allows creating microarrays of nanocomposite materials on receiving substrates, and/or that allows generating products or materials with superior and new properties.

### SUMMARY OF THE INVENTION

The present invention provides a method for laser assisted formation of nanocomposite materials and contactless direct deposit thereof onto a surface of a receiving substrate, comprising the steps of:
- providing one or more sources of laser energy for producing laser energy;
- providing a focusing lens;
- providing a receiving substrate, wherein the receiving substrate is positioned opposite to the source of laser energy;
- providing a laser beam opaque inorganic target, wherein the laser beam opaque inorganic target is positioned between the receiving substrate and the source of the laser energy and wherein the laser beam opaque inorganic target comprises an organic layer that is deposited on the back side of the laser beam opaque inorganic target facing the receiving substrate, said organic layer being of a material having distinct physical or chemical properties from the laser beam opaque inorganic target material;
- providing a support for holding said laser beam opaque inorganic target at a fixed distance relative to said receiving substrate;
- positioning the laser beam opaque inorganic target having the organic layer in a spaced relation to the one or more sources of laser energy so that the laser energy from said one or more sources of laser energy is directed through the focusing lens to strike the laser beam opaque inorganic target comprising the organic layer at the defined target location to perforate the laser beam opaque inorganic target at said target location and create a projection of molten droplets of inorganic material; wherein said projection passes through the organic layer and said molten inorganic droplets ablate the organic material, thereby forming a projection of hybrid nanocomposite material containing inorganic material from the laser beam opaque inorganic target and organic material from the organic layer, wherein said projection of hybrid nanocomposite material is directed to the receiving substrate and said hybrid nanocomposite material is deposited at a defined location on the receiving substrate;
- repeating the steps of positioning and striking the laser beam opaque inorganic target at successive target location, thereby exposing the laser beam opaque inorganic target at said successive defined target location to the one or more sources of laser energy such that the hybrid nanocomposite material is successively deposited at successive defined target locations of the receiving substrate.

The present invention further provides a use of the method of the invention for nanocoating medical devices with pharmaceutical drugs.

The present invention also provides a nanocomposite material obtained by the method of the invention.

### BRIEF DESCRIPTION OF THE FIGURES

Figure 1 shows a schematic representation of an apparatus used to perform the method of an embodiment of the invention.
Figure 2 shows a lateral view of an exemplary segmented laser- opaque target coated on its back side with different organic materials and support.
Figure 3 shows a schematic representation (cross section) of a target showing the distribution of the laser energy in the plane of the focused laser beam.
Figure 4 shows optical and fluorescent micrographs of an transferred Al/Rhodamine 6G nanocomposite material as spots.
Figure 5 shows a fluorescence micrograph of a large-scale array and pattern/line of transferred Al/Rhodamine 6G nanocomposite material.
Figure 6 shows an optical and fluorescent micrographs of an transferred/fabricated/printed nanocomposite material at exceeded/overdose of laser energy with conical forms of arrays.

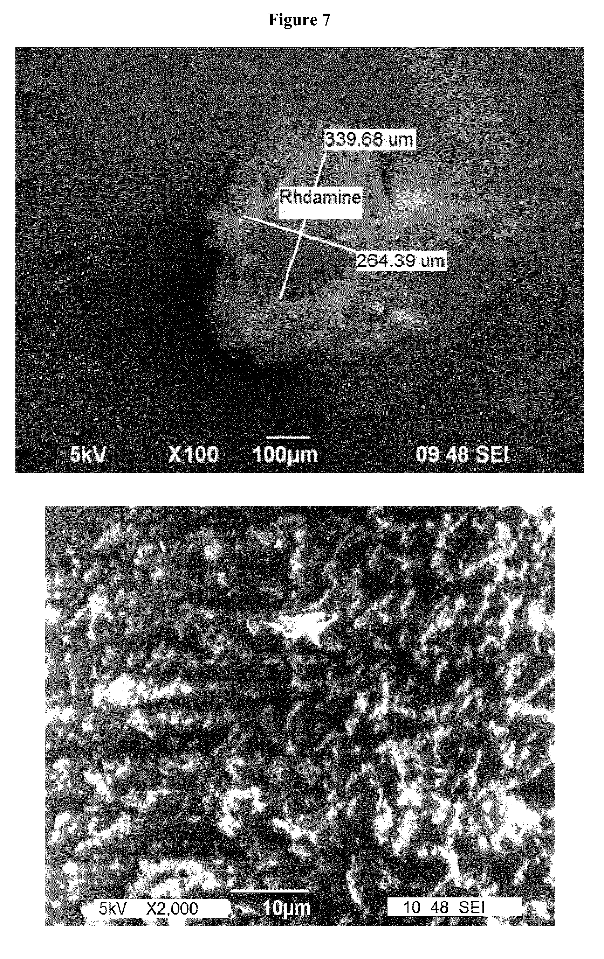

Figure 7 shows Scanning Electron Microscopy (SEM) micrographs on transferred nanocomposite arrays - Al nanoparticles/Rh6G.

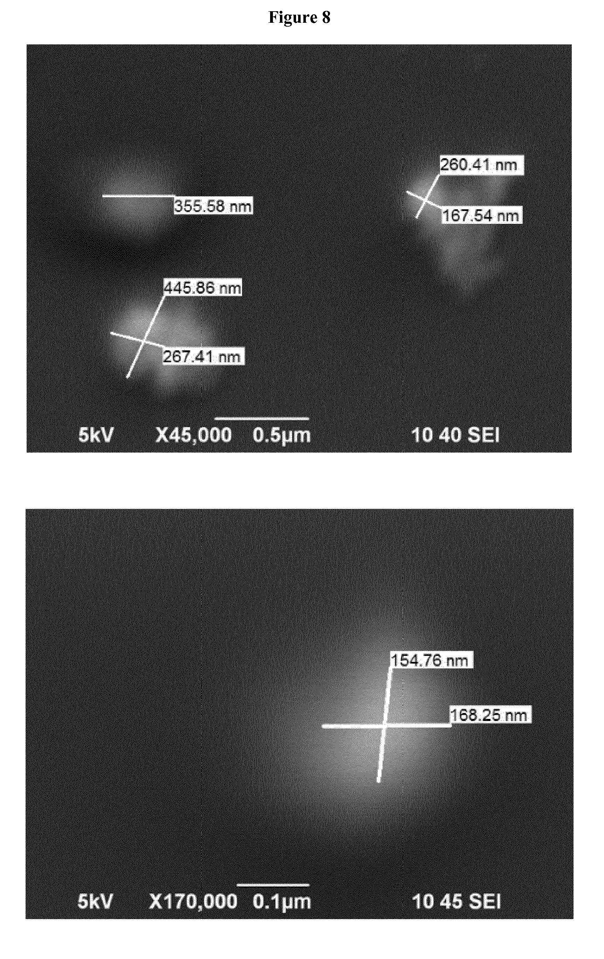

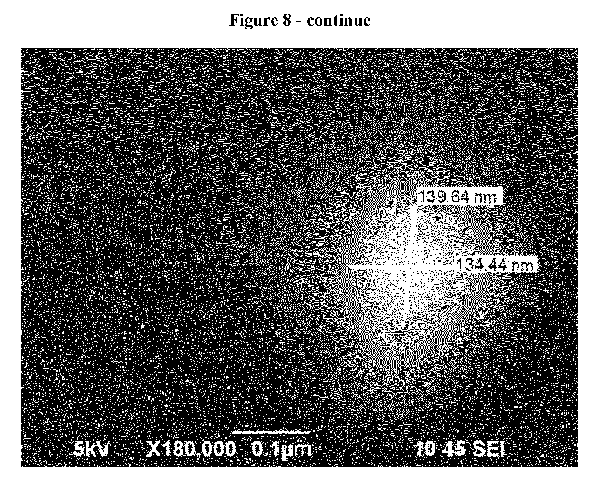

Figure 8 shows Scanning Electron Microscopy (SEM) micrographs on metal Al nanoparticles in the matrix of transferred organic material -Rh6G.

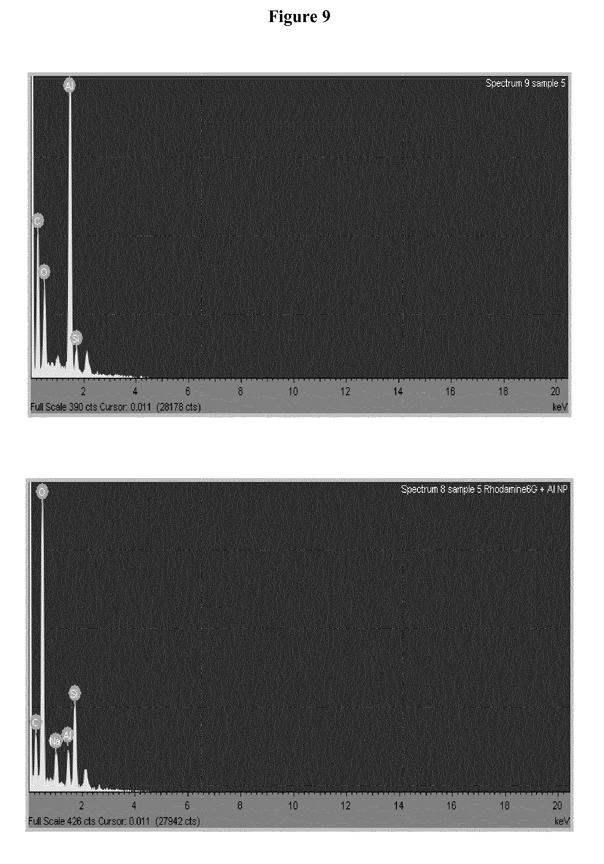

Figure 9 shows exemplary representation of the results of Energy-Dispersive X-ray spectroscopy (EDX) of the formed Al nanoparticles and printing nanocomposite from Al/Rh6G in Al nanoparticles and nanocomposite arrays.
Figure 10 shows Scanning Electron Microscopy (SEM) micrographs on hybrid nanoparticles with Al metal core and organic Rh6G shelf (coating).
Figure 11 shows a fluorescent micrograph and Scanning Electron Microscopy (SEM) micrographs on transferred nanocomposite arrays - Mg nanoparticles/Spidroin.
Figure 12 shows a Scanning Electron Microscopy (SEM) micrographs on metal Mg nanoparticles in the matrix of transferred bioactive material - Spidroin.

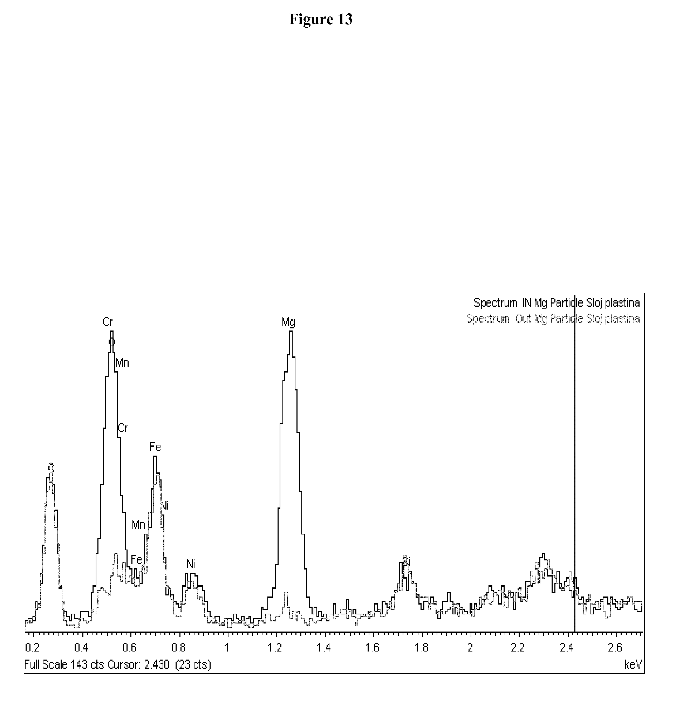

Figure 13 shows exemplary representation of the results of Energy-Dispersive X-ray spectroscopy (EDX) of the formed Mg nanoparticles and printing nanocomposite from Mg/Spidroin in Mg nanoparticles and nanocomposite arrays.

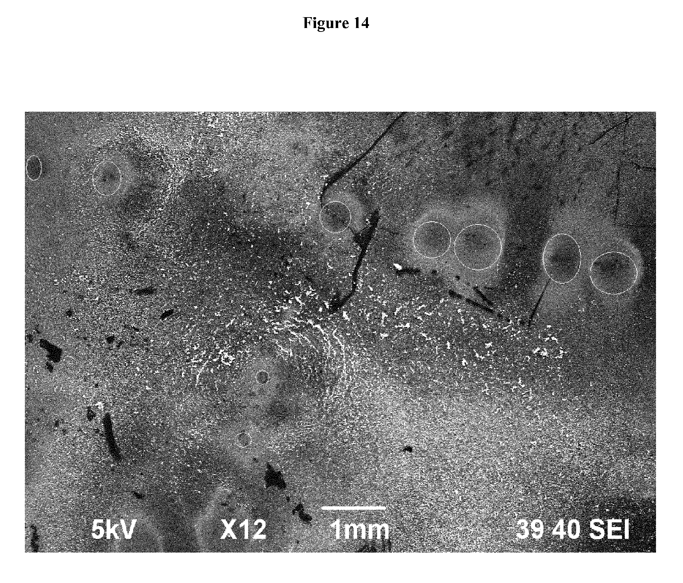

Figure 14. shows panoramic Scanning Electron Microscopy (SEM) micrograph on transferred nanocomposite arrays - Al nanoparticles/Rh6G.

### DETAILED DESCRIPTION OF THE INVENTION

Although methods and materials similar or equivalent to those described herein can be used in the practice or testing of the present invention, suitable methods and materials are described below. All publications, patent applications, patents, and other references mentioned herein are incorporated by reference in their entirety. The publications and applications discussed herein are provided solely for their disclosure prior to the filing date of the present application. Nothing herein is to be construed as an admission that the present invention is not entitled to antedate such publication by virtue of prior invention. In addition, the materials, methods, and examples are illustrative only and are not intended to be limiting.

In the case of conflict, the present specification, including definitions, will control. Unless defined otherwise, all technical and scientific terms used herein have the same meaning as is commonly understood by one of skill in art to which the subject matter herein belongs. As used herein, the following definitions are supplied in order to facilitate the understanding of the present invention.

As used herein, the term "comprise" is generally used in the sense of include, that is to say permitting the presence of one or more features or components.

As used herein, the singular form "a", "an" and "the" include plural references unless the context clearly dictates otherwise.

As used herein, the terms "thin layer" and "thin film" in material combinations are used to describe layers with thicknesses ranging from a few nanometers to several micrometers (for example from 1 nm to 1000 µm), which are applied / deposited to a carrier material/device, hereinafter referred to as target and/or receiving substrate.

The term "direct write" and "direct writing" refers generally to any technique for creating a pattern of deposited material directly on a receiving substrate.

As used herein, the terms "laser", "laser beam", "source of laser energy" are used interchangeably to refer to any device that creates a laser beam.

As used therein, "nanocomposite", "nanocomposite materials" and "nanostructures" designate materials or structures having nano dimensions of 1 nm to 1000 nm. In addition, in the context of the present invention, these terms designate a composition comprising at least two components (two phases). For example, herein referred hybrid nanocomposite material designate a composition comprising inorganic material (phase) and organic material (phase), i.e. materials whose physical and/or chemical properties are very different from each other.

The present invention provides a method for laser assisted formation of nanocomposite materials and contactless direct deposit thereof onto a surface of a receiving substrate, comprising the steps of:
- providing one or more sources of laser energy for producing laser energy;
- providing a focusing lens;
- providing a receiving substrate, wherein the receiving substrate is positioned opposite to the source of laser energy;
- providing a laser beam opaque inorganic target, wherein the laser beam opaque inorganic target is positioned between the receiving substrate and the source of the laser energy and wherein the laser beam opaque inorganic target comprises an organic layer that is deposited on the back side of the laser beam opaque inorganic target facing the receiving substrate, said organic layer being of a material having distinct physical or chemical properties from the laser beam opaque inorganic target material;
- providing a support for holding said laser beam opaque inorganic target at a fixed distance relative to said receiving substrate;
- positioning the laser beam opaque inorganic target having the organic layer in a spaced relation to the one or more sources of laser energy so that the laser energy from said one or more sources of laser energy is directed through the focusing lens to strike the laser beam opaque inorganic target comprising the organic layer at the defined target location to perforate the laser beam opaque inorganic target at said target location and create a projection of molten droplets of inorganic material; wherein said projection passes through the organic layer and said molten inorganic droplets ablate the organic material, thereby forming a projection of hybrid nanocomposite material containing inorganic material from the laser beam opaque inorganic target and organic material from the organic layer, wherein said projection of hybrid nanocomposite material is directed to the receiving substrate and said hybrid nanocomposite material is deposited at a defined location on the receiving substrate;
- repeating the steps of positioning and striking the laser beam opaque inorganic target at successive target location, thereby exposing the laser beam opaque inorganic target at said successive defined target location to the one or more sources of laser energy such that the hybrid nanocomposite material is successively deposited at successive defined target locations of the receiving substrate.

Preferably, the method of the present invention is controlled by a computer and is carried out at ambient conditions.

Preferably, the source of laser energy is a pulsed laser.

Preferably, the receiving substrate comprises a non-planar surface.

Preferably, the laser beam opaque inorganic target is of any inorganic material selected from the group comprising metals, metal alloys, metal oxides, dielectrics, semiconductors, carbon. More preferably metals are selected from the group comprising alkaline earth metals (such as magnesium and calcium), alkali metals (such as sodium and potassium), elements of group 13 (XIII) of the Periodic Table of Elements (such as aluminium), transition metals of groups 3, 4, 5, 6, 7, 8, 9, 10, 11 and 12 of the Periodic Table of Elements (such as iron, cobalt, nickel, copper, zinc, silver, rhodium, gold, platinum, tungsten, titanium).

Preferably, the receiving substrate is made of one or more materials selected from the group comprising chemically functionalized glass, polymer-coated glass, quartz, natural hydrogel, synthetic hydrogel, uncoated glass, nitrocellulose coated glass, silicon, glass, plastics, metals, and ceramics.

Preferably the organic layer comprises one or more organic or bioactive materials selected from the group comprising chemical compounds, pharmaceutical drugs, organic polymers, dyes, peptides, proteins, recombinant proteins, DNA, portions of DNA strands, RNA, a layer of stained or fixed tissue, a layer of living tissue, and functional supporting media such as nutrients and other life supporting material.

The method of the present invention allows the production of thin layers (or thin films) of nanostructures or nanocomposite materials on areas (surfaces) of micro- and nano- dimensions or the creation of microarrays made of materials whose physical and/or chemical properties are very different, for example hybrid nanocomposite materials, in one step and in one technological cycle. It allows also building 2D and 3D nanocomposites onto different types of receiving substrates. In addition, the method of present invention avoids damaging the components (phases) of the transferred material (such as organic material) as well as the receiving material of the receiving substrate. Specifically many organic materials, such as organic polymers, peptides or cells, are fragile, thermally labile, and can be irreversibly damaged by direct exposure to the laser energy. This is avoided in the method of the present invention by placing the organic material on the back side of the laser beam opaque inorganic target, i.e. on the side opposite that of the impact of the laser energy (laser beam) on the laser beam opaque inorganic target.

It is well known that nanoparticles can be produced by laser ablation technique and that uniform metal nanoparticles are synthesized by laser ablation of thin metal layer. This technique prevents splashing of large nanoparticles and minimal nanoparticles agglomeration. It is also known that the energy distribution within a focused laser beam is non-uniform and density of the laser energy in axial direction can vary by several orders of magnitude and this variation is not linear.

The method of the present invention takes advantage of the laser ablation technique and uses the non-uniform intensity (non-uniform energy distribution) over the cross-section of the focused laser beam for direct transfer of organic or more complex materials, such as biological active materials, depositing in one step and one technological cycle hybrid nanocomposite or complex nanostructures on determined micro- and nano- areas on receiving substrates, and/or creating microarrays of hybrid nanocomposite materials on receiving substrates, and/or that allows generating products or materials with superior and new properties.

In contrast to many laser-induced forward transfer mechanisms (LIFT), the method of the present invention does not use laser-transparent target substrate with material film coated on the opposite side of the transparent target substrate and do not rely on the use of a plume of ablated material from the dynamic release layer (DRL) to transfer the material(s) or selectively absorbing light energy materials or specific selected photon energy.

The material of the laser beam opaque inorganic target may be any inorganic material, such as metals, metal alloys, metal oxides, dielectrics, semiconductors. The preferred thickness of the laser beam opaque inorganic target is in range of 1 µm to 300 µm.

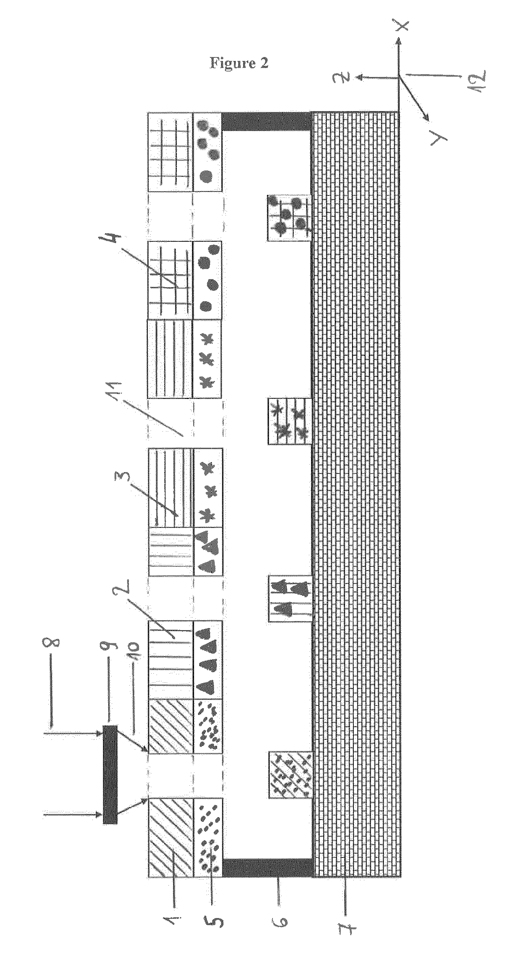

According to an embodiment of the present invention, the laser beam opaque inorganic target may be segmented into several segment, for example at least two, three or four segments (see Figure 2). Segments may be regions and/or planes. The form of segments has no restriction. The segments may comprise materials of same or different physical and/or chemical properties in each segment. It may for example comprise a first segment comprising a metal material, a second segment comprising a ceramic material, and a third segment comprising a semiconductor material. The segments may be located in a single plane or their thickness may be different.

The back side of the laser beam opaque inorganic target (i.e. the side facing the receiving substrate) is coated with organic materials which may be different for different segments if the laser beam opaque inorganic target is segmented into several segments. The organic or biological active materials are coated on the back side of the laser beam opaque inorganic target prior to performing the method of the present invention. Multilayer compatible organic structures can be formed on the back side of the laser beam opaque inorganic target (or onto segments).

For the deposition (coating) of an organic thin layer (thin film) on the laser beam opaque inorganic target, organic materials/compounds are applied to said inorganic target by various methods of thin-film technology known in the art, such as spin coating, spray coatings, dip coating, polymerization, sputtering or others. The thickness of the organic thin layer (thin film) is usually similar to the thickness of the laser beam opaque inorganic target, but has no restrictions, as the thickness of the organic thin layer may be bigger in comparison of the thickness of the laser beam opaque inorganic target. The preferred thickness of the organic thin layer is in range 1 µm to 300 µm or it can be also less than 1µm.

Alternatively, an organic thin layer (thin film) can be previously prepared and contacted with the back side of the laser beam opaque inorganic target.

According to embodiments of the present invention, the laser beam opaque inorganic target can contain more than one organic layer, such as two, three, four, five or more organic layers on the back side of the laser beam opaque inorganic target.

According further embodiments of the present invention, the laser beam opaque inorganic target can contain at least one additional inorganic layer (thin layer), such as two, three, four, five additional inorganic layers, on the back side, on the front side or both sides of the laser beam opaque inorganic target. The at least one additional inorganic layer comprises an electronic material selected from the group comprising metal, dielectric, resist, semiconductor, and combinations thereof; and wherein one or more electronic materials are used to create electronic circuitry on the receiving substrate.

According to a further embodiment of the present invention, the laser beam opaque inorganic target can contain at least one organic layer (thin layer) on the back side of the laser beam opaque inorganic target and at least one inorganic layer (thin layer) placed on the back side, front side or both sides of the laser beam opaque inorganic target.

The receiving substrate can be any solid material, planar or non-planar, onto which one may wish to deposit the hybride nanocomposite material. The receiving substrate can comprise one or more materials selected from the group comprising chemically functionalized glass, polymer-coated glass, quartz, natural hydrogel, synthetic hydrogel, uncoated glass, nitrocellulose coated glass, silicon, glass, plastics, metals, and ceramics. The receiving substrate can comprise functionalization that interacts with the deposited hybride nanocomposite material. The functionalization is selected from the group comprising covalent functionalization, physisorbed functionalization, and combinations thereof. Surfaces with functionalization can be prepared by any method known in the art. Surfaces with functionalization can also occur naturally, such as a living host. Covalent functionalization is when the deposited hybrid nanocomposite material becomes covalently bonded to the surface of the receiving substrate. Physisorbed functionalization is when the deposited hybrid nanocomposite material becomes attached or adsorbed to the receiving substrate by means other than covalent bonding. Examples of functionalization include a living host, a living cell, a living cell culture, a non-living cell, a non-living group of cells, a living tissue, a chemically functionalized surface, and a biologically functionalized surface.

Any suitable laser source may be used in the present invention. In general, a pulsed laser is preferred with very short pulse in ns, ps or fs pulse duration. The short and ultra-short laser pulse prevent damage and defragmentation of organic or bioactive material deposited on the back side of laser beam opaque inorganic target. The short laser pulse prevent formation of liquid phase/melting at interaction with the laser beam opaque inorganic target. The pulsed lasers are commercially available within the spectral range from UV to IR. Examples of suitable lasers include, but are not limited to, pulsed gas lasers such as excimer lasers, i.e. F2 (157 nm), ArF (193 nm), KrF (248 nm). XeCl (308 nm), XeF(351 nm), pulsed solid state and fiber lasers such as Nd:YAG (1,06 µm), Ti:Sapphire (about 780 nm), Yb+, Er+ ,Ruby, diode pumped lasers, semiconductor lasers, CO2, N2(337,1 nm), metal vapor, etc. and pulsed dye laser systems. Typically, the particular laser is selected with regard to the energy needed to ablate material from laser beam opaque inorganic target without or very small melting phase, to create hole with minimal heat affected zone (HAZ) and with minimal dimensions and to interact with organic material of the back side of the laser beam opaque inorganic target without damage or defragmentation. The energy density should be high enough to create hole (or perforation) in the laser beam opaque inorganic target but not so high that the laser energy damages the transfer of organic material. When the laser beam opaque inorganic target has high reflection regarding wave length of laser beam and the organic material on back side is an active biomaterial, a typical range of energy density is about 5 mJ/cm² to about 700 mJ/cm². Higher energy densities are also possible. The particular laser is selected depending on beam profile, divergence of beam and point stability. Preferred selected lasers are with rotationally symmetrical Gaussian beam and M2 - beam propagation factor near to 1. The energy distribution within a focused laser beam is non-uniform and density of the laser energy in axial direction can vary by several orders of magnitude and this variation is not linear. The method of the invention uses this property as the area with biggest laser energy is fixed on the surface of the laser beam opaque inorganic target. The focusing lens is preferably selected that the length -"waist" of focused laser beam corresponds to the thickness of the laser beam opaque inorganic target and decreasing of laser energy in conjunct with thickness of organic material on the back side. The laser energy, i.e. the tightly focused laser beam is directed onto surface of the laser beam opaque inorganic target so that it strikes the laser beam opaque inorganic target. A part of the laser energy is reflected, another part is absorbed by the laser beam opaque inorganic target. A density of laser energy is selected so that it is mainly absorbed by the laser beam opaque inorganic target. The absorbed laser energy is transformed into energy that ablates / ejects material (i.e. atoms and/or molecules) from laser beam opaque inorganic target providing a drill hole, i.e. the laser energy perforates the laser beam opaque inorganic target. The ablation process forms a projection of material (atoms and molecules) which is directed to the receiving substrate through the organic layer. The projection passing through the organic layer on the back side of the laser beam opaque inorganic target is low energy, contains small molten inorganic droplets of inorganic material from the laser beam opaque inorganic target (said droplets can have micro- and/or nano-scale dimensions) and its energy decreases by interaction with the organic material. These small molten inorganic droplets of interact with the organic material from the back side of the laser beam opaque inorganic target and transmit their energy to said organic material. The energy of defocused laser beam and the energy of small molten inorganic droplets are enough for selective separation (ablation) of the organic material. In the space (gap) between the laser beam opaque inorganic target having the organic layer on the back side and the receiving substrate, thermalization and formation of new nanocomposite materials or nanostructures occurs, which contain material from the laser beam opaque target and organic material from the organic layer on the back side of the laser beam opaque target, thereby providing new nanocomposite materials of new and advantageous properties. The obtained nanocomposite materials or nanostructures can be deposited at defined receiving location on the receiving substrate. Said location can be for example either micro- or nano- area on the receiving substrate or a microarray of organic material. The space (gap) between laser beam opaque inorganic target with the organic layer on the back side and the receiving substrate should be enough so that new nanocomposite material or nanostructure have time for forming and enough energy for adhering to the receiving substrate. Thus usually the space (gap) between the laser beam opaque inorganic target and the receiving substrate is substantially bigger from the thickness of the laser beam opaque inorganic target with the organic layer on the back side. Preferably, the receiving substrate is positioned at about 5 µm to 800 µm distance from the surface of the organic layer on the back side of the laser beam opaque target.

The form and the material of the support holding the laser beam opaque inorganic target in a fixed distance relative to the receiving substrate can be of any type, but it must fix the laser beam opaque inorganic target and the receiving substrate at a determined distance from each other. Said distance can be different in different embodiments of the invention and is for example determined on the basis of the material of the laser beam opaque inorganic target, the organic material of the organic layer, the nature of the receiving substrate and/or the power of the laser energy and can thus be adapted to one or more of these parameters, for example by adapting the support and/or by choosing an support with adapted dimensions. Optionally the support can also fix the laser bean opaque inorganic target in stationary position relative to the receiving substrate, so that the laser bean opaque inorganic target is moved together with the receiving substrate during deposition of the hybrid nanocomposite material.

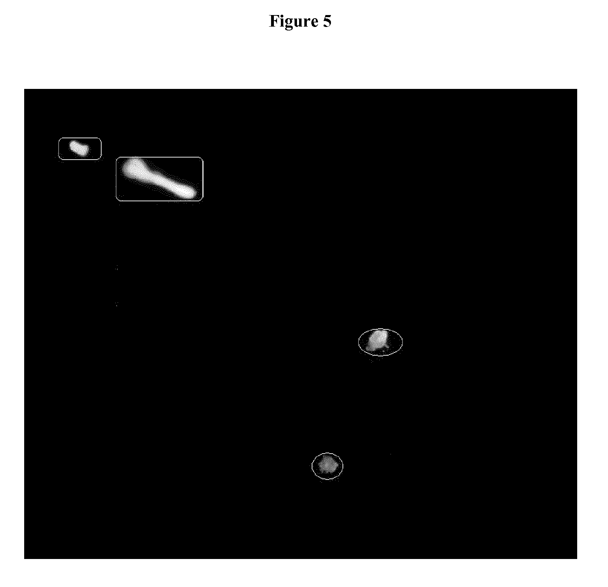

In the case when the energy of laser beam is bigger, not uniform or the biggest laser energy (the waist) is not fixed on the surface of the laser beam opaque inorganic target, conical nanocomposite structures can be formed and transferred (see Figure 5).

The dimensions of the laser energy can be controlled by any means known in the art so that only a precisely defined area of the laser beam opaque inorganic target is exposed to the laser energy and so that only a precisely defined portion of the material is ablated. The laser energy can be focussed through an objective to narrow the beam and ablate a portion of the laser beam opaque inorganic target material. It is possible to focus the laser energy so that it is small enough to transfer a single cell to the receiving substrate from the organic layer containing a cluster of cells. Single cell transfers can also be achieved by using a very dilute concentration of cells in the organic layer.

Preferably, the method of the present invention is carried out at ambient conditions, such as at about room temperature and at about atmospheric pressure. The method can also be carried out under one or more controlled conditions, such as humidity, pressure, vacuum, temperature, atmospheric composition, air pressure, and/or sterility. Controlled conditions may also include use of inert gases (such as helium, argon, neon, krypton, xenon or nitrogen), oxygen, alcohols, hydrocarbons and/or combination thereof (for example helium/argon).

Positioning the laser beam opaque inorganic target and/or the receiving substrate, and/or positioning the source of laser energy, in order to strike the inorganic target at a defined (determined) position (location) is achieved through the use of one or more positioning means. These positioning means can be any positioning means known in the art for supporting the source of laser energy and/or the laser beam opaque inorganic target, for example together with the receiving substrate, and moving them in a controlled and defined manner. For example, to deposit hybrid nanocomopsite materials on the receiving substrate and thereby create a pattern/line or microarray of hybrid nanocomposites on the receiving substrate, the laser beam opaque inorganic target (having an organic layer), which is for example fixedly attached to the receiving substrate by supports, is placed on a CNC coordinate device and moved relative to the static source of laser energy (laser beam). The CNC coordinate device, preferably a CNC coordinate table, is connected to or comprises a controller device, for example a computer capable of carrying out an algorithm designed to automatically provide movements to said CNC coordinate device in desired directions, such as 2D directions or 3D directions. Of course, it is understood that both the CNC coordinate device and the controller device would be connected to a power supply. The movement velocity of the laser beam opaque inorganic target having an organic layer is for example from 10 µm/s to 1000 µm/s, preferably 500 µm/s. Alternatively, the source of laser energy and/or the laser beam can move relative to the laser beam opaque inorganic target (having an organic layer) and the receiving substrate, which are static in this case. The laser or the laser beam velocity can be for example from 10 µm/s to 1000 µm/s, preferably 500 µm/s. Commercially available, computer-controlled translation stages or galvanometric laser scanning devices may be used for rapid motion and high-resolution patterns from the individually synthesized and written 2D or 3D areas or arrays from transferred nanocomposite materials.

To increase the thickness of deposited hybrid nanocomposite material and/or to deposit several successive layers of different hybrid nanocomposite materials, in case when the laser beam opaque inorganic target for example comprises several segments containing different inorganic and/or organic material, at a particular defined receiving location on the receiving substrate, the source of the laser energy and/or the laser beam and the receiving substrate can be held stationary with respect to each other and the laser beam opaque target is moved with respect to the laser beam. The laser energy is thus directed to a new defined target location on the laser beam opaque inorganic target, having the organic layer, where the material has not yet been ablated. The hybrid nanocomposite material is deposited onto the same defined receiving location on the receiving substrate, thereby forming a deposit of increased thickness and/or different deposited hybrid nanocomposite material.

The positioning techniques described above can also be combined in order to deposit several successive structured layers of different hybrid nanocomposite materials on a single receiving substrate.

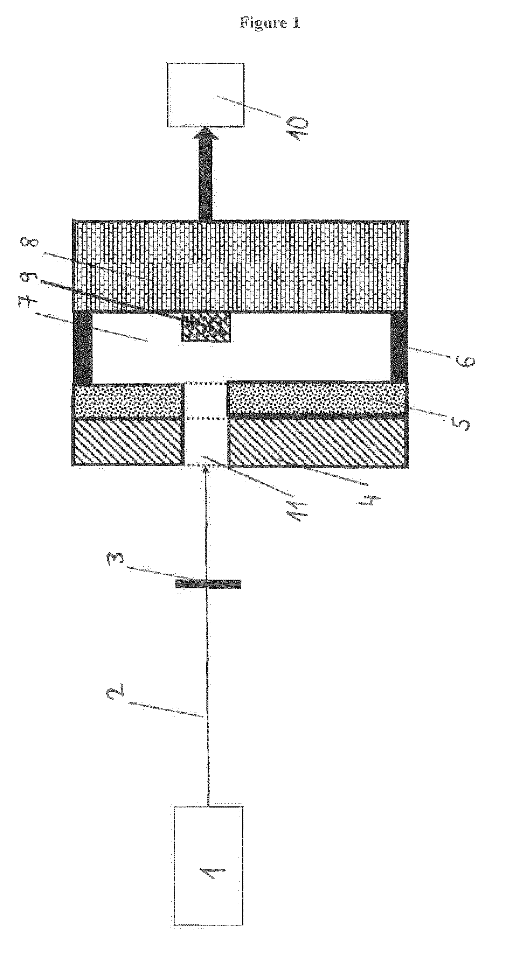

Figures 1 to 3 show schematic representation of arrangements for performing the method of the present invention. The illustrated embodiments are purely illustrative and in no way limiting. In particular, the arrangement can be varied, for example to adapt different components to various applications and/or to manufacturing constraints, material limitations, etc.

Figure 1 shows a schematic representation of an arrangement for performing the method according to an embodiment of the present invention for direct deposition of nanocomposites and nanostructures. The method uses a laser source 1 that produce laser energy (i.e. laser beam) 2, focusing lens 3, laser beam opaque inorganic target 4, organic layer of organic or bioactive material 5, which is placed in contact on the back side of the laser beam opaque inorganic target 4, support 6 which forms a space (gap) 7 between the laser beam opaque inorganic target 4 coated on the back side with organic layer 5, receiving substrate 8, transferred nanocomposite material or nanostructure 9, CNC coordinate table 10. The laser beam opaque inorganic target 4 and organic layer 5 placed in contact on the back side of the laser beam opaque inorganic target 4 can be planar or non planar. The laser beam opaque inorganic target 4 can be any solid material as metals, alloys, ceramics, semiconductors, carbon. The organic or bioactive material 5 can be any organic materials such as drugs, organic polymers, dyes, peptides, proteins, recombinant proteins, or biomaterial in its active or living state. An active biomaterial is one that is capable of performing its natural or intended biological function. Suitable biomaterials can comprise any of the following examples, but are not limited to these examples: recombinant proteins as Spidroin, DNA, portions of DNA strands, RNA, protein, a layer of stained or fixed tissue, a layer of living tissue, and functional supporting media such as nutrients and other life supporting material.

The receiving substrate **8** can be planar or non planar. The receiving substrate **8** may be of any solid material such as metals, polymers, carbon, glass, chemically functionalized glass, polymer coated glass, quartz, natural hydrogel, synthetic hydrogel, uncoated glass, nitrocellulose coated glass, plastics, semiconductors and ceramics.

The source of laser energy **1** is positioned in a spaced relation to the laser beam opaque inorganic target **4,** so that the laser energy, i.e. the laser beam **2** will strike the laser beam opaque inorganic target **4** with organic layer of organic or bioactive material **5,** which is placed in contact on back side of the laser beam opaque inorganic target **4** at a defined target location and with defined density of laser energy. The laser energy **2** is sufficient energy to cause hole **11** (or perforation) in the laser beam opaque inorganic target **4** having a layer of organic or bioactive material.

The laser 1 (Figure 1), the laser beam opaque inorganic target **4,** and the receiving substrate **8** should be moveable with respect to each other so that the nanocomposite material **9** can be deposited in a microarray and so that after the nanocomposite material **9** ablated (ejected, separated) from one defined target location on the laser beam opaque inorganic target **4,** the laser beam **2** can be directed to another defined target location on the laser beam opaque inorganic target **4** where the nanocomposite material **9** has not yet been ablated (ejected, separated). For example, according to an embodiment of the present invention, to deposit a line of nanocomposite material **9** on the receiving substrate **8,** the laser beam **2** is moved with respect to the laser beam opaque inorganic target substrate **4** and the receiving substrate **8,** which may be held stationary with respect to each other. As the laser beam **2** moves, the laser beam **2** is directed to a new defined target location on the laser beam opaque inorganic target substrate **4,** where the nanocomposite material **9** has not yet been ablated, and causes the nanocomposite material **9** to be deposited onto a new defined receiving location on the receiving substrate **8.** The successive defined receiving location may overlap to the extent necessary to create a continuous line of deposited nanocomposite material **9** on the receiving substrate **8.**

To increase the thickness of deposited nanocomposite material or to form 3D nanostructure **9** (Figure 1) at a particular defined receiving location, the laser beam **2** and the receiving substrate **8** are held stationary (static) with respect to each other and the laser beam opaque inorganic target **4** is moved with respect to the laser beam **2** and the receiving substrate **8.** The laser beam **2** is directed to a new defined target location on the laser beam opaque inorganic target **4** where the nanocomposite material **9** has not yet been ablated (ejected, separated) and transferred. The nanocomposite material **9** is deposited onto the same defined receiving location on the receiving substrate **8** in an increasingly thickened deposit or forms 3D nanostructure. The movements can be also in rotational planes.

Figure 2 shows a lateral view of an exemplary segmented laser beam opaque inorganic target coated on back side with different organic materials according to an embodiment of the present invention. The segmented laser beam opaque inorganic target coated on back side with different organic materials comprises, for example metal laser beam opaque inorganic target **1** coated on back side with an organic material **5**, dielectric laser beam opaque inorganic target **2** coated on back side with an organic material **5**, semiconductor laser beam opaque inorganic target **3** coated on back side with an organic material **5**, ceramic laser beam opaque inorganic target **4** coated on back side with an bioactive material **5**. The segmented laser beam opaque inorganic targets **1, 2, 3, 4** coated on the back side with different organic and/or bioactive materials are placed in nests with holes on holder (not shown). The holder is fixed on support **6,** which forms a gap 7 between the laser beam opaque inorganic targets **1, 2, 3, 4,** having on the back side organic or bioactive materials, and the receiving substrate 7. The distance between segmented and coated laser beam opaque inorganic targets and the receiving substrate **7** is equal for all segmented laser beam opaque inorganic targets **1, 2, 3, 4.** The thickness of segmented laser beam opaque inorganic targets **1, 2, 3, 4** may to be different. The source of laser energy **8** is positioned in a spaced relation to the laser beam opaque inorganic targets **1, 2, 3, 4,** so that the laser energy, i.e. laser beam **10** will strike through the focusing lens 9 the laser beam opaque inorganic targets **1, 2, 3, 4** having organic or bioactive materials placed in contact on back side of the laser beam opaque inorganic target **4** at a defined target location and with defined density of laser energy. Each individual segment **1, 2, 3,** and **4** can be of any desired shape, for example, circular, rectangular, elliptical or any other complex shape. The laser energy. i..e the laser beam **10** is sufficient energy to cause holes **11** in the laser beam opaque inorganic targets **1, 2, 3, 4.** The defined targets **1, 2, 3, 4** location with defined density of laser energy are achieved by using CNC 3 axis coordinate table **12** or scanning device, which adjust the place of the laser beam opaque inorganic targets **1, 2, 3, 4** in 3 axis. The density of the laser energy, i.e. the laser beam **10** can be controlled by any means known in the art so that only a precisely defined area of the targets **1, 2, 3, 4** is exposed to the laser energy. Preferably, the method is controlled by a computer. It is possible to use several laser sources for the each segment of segmented laser beam opaque inorganic target coated of back side with different organic materials.

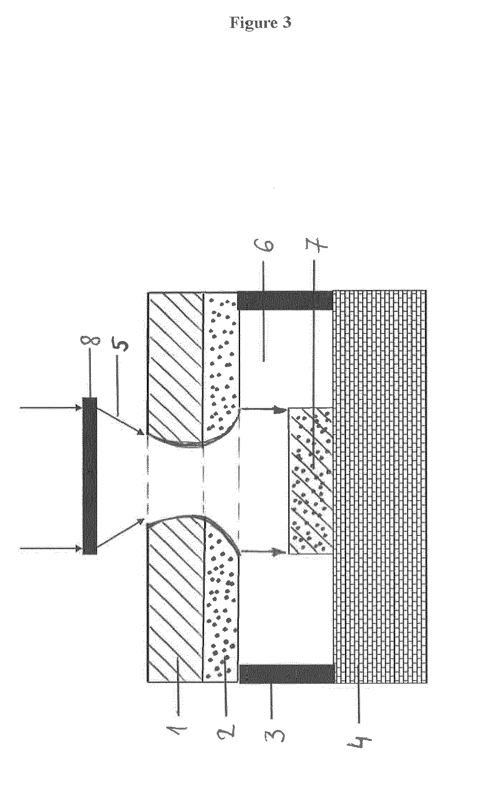

Figure 3 is a schematic representation (cross section) of an arrangement for performing the method according to an embodiment of the present invention showing distribution of the laser energy in the plane of the laser energy - focused laser beam **5** (focusing lens **8).** The laser beam opaque inorganic target **1** is typically planar. The composition/material of the laser beam opaque inorganic target **1** is selected in accordance with the particular nanoparticles or nanostructures that must be synthesized and in accordance to the used laser source. On the back side of the laser beam opaque inorganic target **1** is placed organic material in form of layer (thin layer) **2** with direct contact with the laser beam opaque inorganic target **1.** The formation of organic layer can be realized with any existing techniques for deposition of organic layers such as spin coating, spray coatings, dip coating, polymerization or others. The thickness of organic layer (thin layer) **2** is similar to the thickness of the laser beam opaque inorganic target **1** but has no restrictions as the thickness of organic layer may be dick in comparison of the thickness of the laser beam opaque inorganic target **1.** The preferred thickness of the laser beam opaque inorganic target **1** and the organic layer **2** are in range 1 µm to 300 µm. The support **3** serves for forming the space (gap) **6** between the laser beam opaque inorganic target **1** with the organic layer **2** on back side and the receiving substrate **4.** The form and the material of the support **3** can be of any type, but must fix the laser beam opaque inorganic target **1** with organic layer **2** and the receiving substrate **4** at fixed distance relative to one another. The space (gap) **6** between the laser beam opaque inorganic target **1** with organic layer **2** and the receiving substrate **4** is determined by the support.

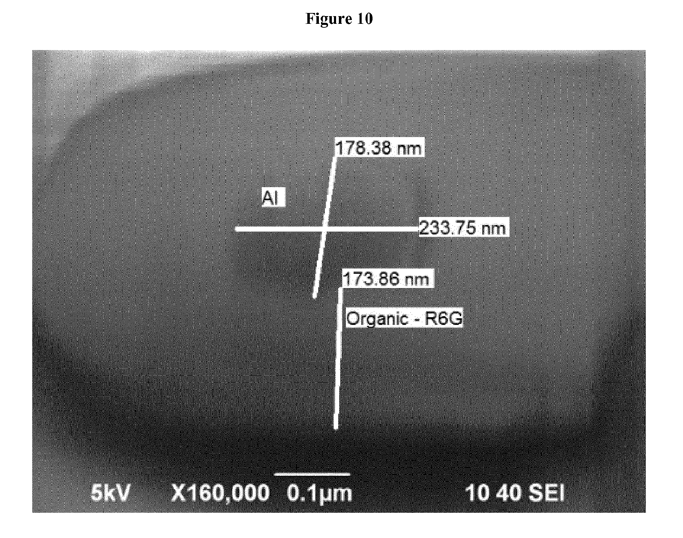

According to another embodiment of the present invention, the method of the invention can be used to synthesise (prepare) hybrid nanocompositions or hybride nanocomposite materials (see Figure 10) consisting of a metal core or other inorganic nanoparticle core coated with organic compounds. These nanocompositions are obtained by simply replacing the receiving substrate by a container, which collects said nanocompositons. The container should be placed at a distance (for example from 1mm to 1cm) sufficient to allow the energy of nancompositions to lower in order to avoid that the nanocompositions adhere on the surface of the container. The hybrid nanocompositions have different properties than inorganic components and organic compounds alone. This includes but is not limited to the properties such as thermal, optical, dielectric, strength, electrical conductivity and/or combination thereof. For example, polymer nancompositions having metal cores have different electrical, chemical, mechanical and/or physical properties than polymer nanocompositions alone.

The method of the present invention can be used to provide nanocoatings with medical applications and industrial applications, such as aerospace, automobile, nano-catalyst and electronic industries.

The method of the present invention can be particularly well used for nanocoating medical devices with pharmaceutical drugs, said medical devices being selected from the group comprising stents, catheters or drug eluting balloons. Nanostructured drug delivery system plays a key role to improve the time release of drug molecules and enable more precise drug targeting.

The method of the present invention can provide hybrid nanocomposite coatings of medical devices, with precise drug dose adjustment, which functions as programmed drug delivery device. The hybrid inorganic-organic nanocomposite coatings can contain inorganic nanoparticles, such as Mg, Fe, Al or Ca and drug(s) or more complex organic materials, such as peptides or proteins.

Those skilled in the art will appreciate that the invention described herein is susceptible to variations and modifications other than those specifically described. It is to be understood that the invention includes all such variations and modifications without departing from the spirit or essential characteristics thereof. The invention also includes all of the steps, features, compositions and compounds referred to or indicated in this specification, individually or collectively, and any and all combinations or any two or more of said steps or features. The present disclosure is therefore to be considered as in all aspects illustrated and not restrictive, the scope of the invention being indicated by the appended Claims, and all changes which come within the meaning and range of equivalency are intended to be embraced therein.

Various references are cited throughout this Specification, each of which is incorporated herein by reference in its entirety.

The foregoing description will be more fully understood with reference to the following Examples. Such Examples, are, however, exemplary of methods of practicing the present invention and are not intended to limit the scope of the invention.

### EXAMPLES

### Example 1

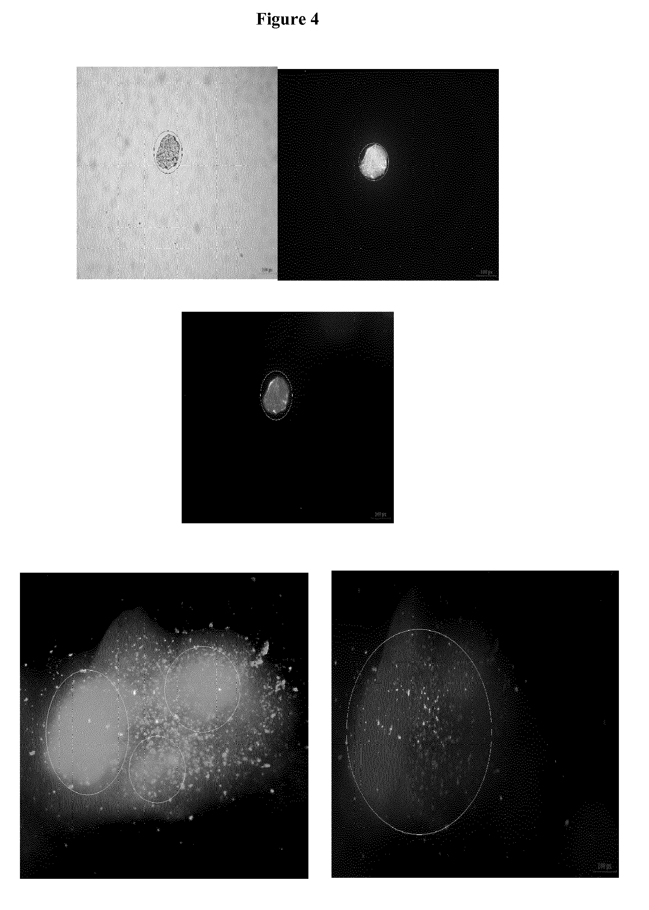

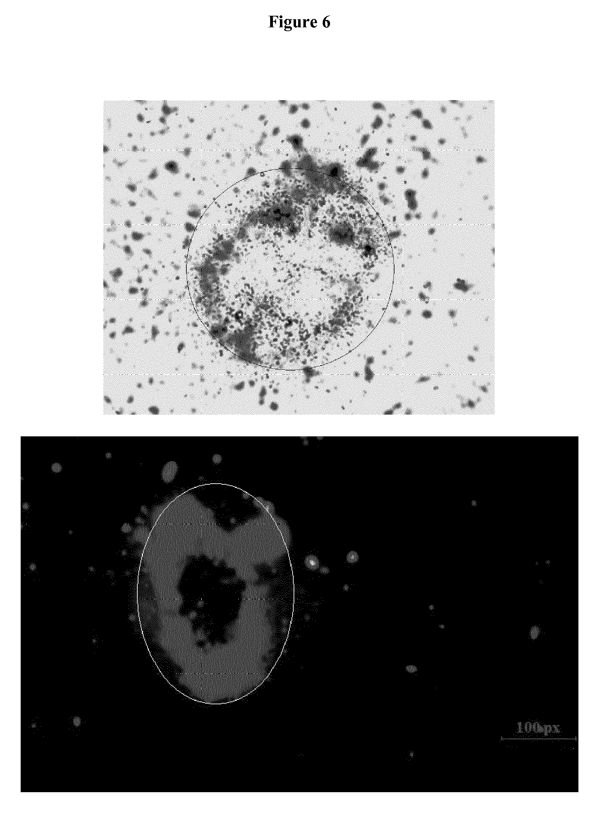

To create/synthesize of a micro-array of metallic-organic hybrid nanocomposite material in one step and in one technological cycle an aluminum (Al) laser beam opaque inorganic target (for example see Figure 3, laser beam opaque target **1)** was used with thickness 50 µm, purity 98% and area of 4 cm². On the back side of Al laser beam opaque inorganic target was deposited an organic layer of Rhodamine 6G (Rh6G), an organic fluorescent dye (Sigma Aldrich) by spin coating having a layer thickness of 7 µm (for example see Figure 3, organic layer **2).** The receiving substrate (for example see Figure 3, receiving substrate **4)** was glass slide with thickness 200 µm, area of 4 cm², previously cleaned in ultrasonic bad with acetone, ethanol and deionized water and dried with argon (Ar). The receiving substrate was positioned on 600 µm from the surface of organic layer Rhodamine 6G on back side of laser beam opaque inorganic target using four steel supports (for example see Figure 3, support 3). The aluminum (Al) laser beam opaque inorganic target with deposited organic layer of Rhodamine 6G and glass receiving substrate positioned opposite to Al laser beam opaque target at 600 µm distance from the surface of the organic layer were fixed on CNC coordinate table. A TEA Nitrogen (N2) laser with a wavelength of 337.1 nm, a pulse duration of 4 ns and an energy per pulse of 0,8 mJ and a repetition rate of up to 100 Hz was directed by meniscus quartz lens at the surface of aluminum (Al) laser beam opaque inorganic target. The repetition rate of the laser pulse was 1Hz and the laser energy density ranged from 300 mJ/cm² to 500 mJ/ cm² onto surface of laser beam opaque inorganic Al target. To create a pattern/line from metallic-organic hybrid nanocomposite material in one step and in one technological cycle the aluminum (Al) laser beam opaque inorganic target with deposited organic layer of Rhodamine 6G and glass receiving substrate positioned opposite to inorganic laser beam opaque target at 600 µm distance from the surface of the organic layer were moved with velocity of 500 µm/s in respect to the focused laser beam by means of CNC coordinate table controlled by a computer. When laser energy density was more than 500 mJ/ cm² on the receiving substrate were created conical arrays from hybrid nanocomposite material. In a process with exceeded/overdose of laser energy part form ablated material was reached to already ready transferred hybrid nanocomposite material (see Figure 6). The dimensions of laser direct writing nanocomposite arrays were in range from 250 µm to 350 µm. The dimensions of metal (Al) nanoparticles in organic matrix (coating) were in range from 150 nm to 350 nm. The dimensions of hybrid nanoparticles with Al metal core and organic Rh6G shelf were in range: metal core about 200 nm and organic shelf about 250 nm. The process was carried out at ambient conditions. The viability of the transferred arrays and patterns/line were verified through optical/fluorescent detection (fluorescent microscopy) (see Figures 4 and 5). The nanocomposite arrays produced according to the above-mentioned method was examined by scanning electron microscopy (SEM) and energy dispersive x-ray (EDX) spectroscopy.

### Example 2

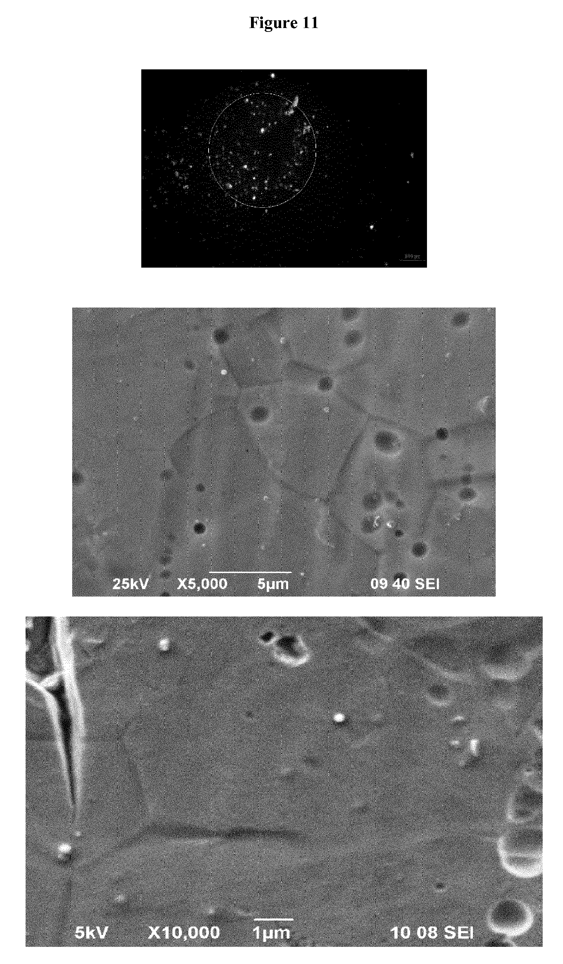

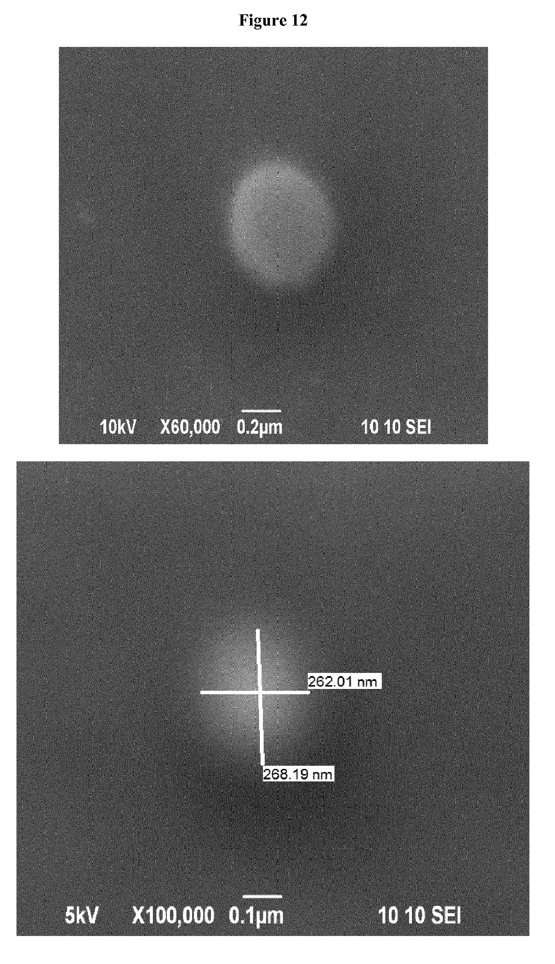

Micro-array nanocomposites material from active biomaterial Spidroin as matrix (coating) and magnesium (Mg) nanoparticles (core) in the matrix in one step and in one technological cycle were prepared. The magnesium (Mg) alloy laser beam opaque inorganic target was used with thickness of 45 µm, purity higher than 99, 5 % and area of 4 cm². The advantages of magnesium are biocompatibility, biodegradability, anticorrosion properties. On the back side of Mg alloy laser beam opaque inorganic target was deposited an organic layer of bioactive material - recombinant silk protein Spidroin (1409 amino acids, molecular weight/mass: 113859.5, atomic composition: Carbon (C) - 4780, Hydrogen (H) - 7180, Nitrogen (N)-1640, Oxygen (O) - 1640, Sulfur (S) - 0, by spin coating having a layer thickness of 10 µm. Before deposition, the lyophilized Spidroin biopolymer was dissolved by standard procedure in 10% lithium chloride and 90% formic acid, dried and cleaned in ethanol. The recombinant silk protein Spidroin is biocompatible and biodegradable and has unique thermo-mechanical properties. The receiving substrate was stainless steel 316L plate with thickness 300 µm, area of 4 cm², previously cleaned in ultrasonic bad with acetone, ethanol and deionized water and dried with dry argon (Ar). The receiving substrate was positioned at 400 µm distance from the surface of the bioactive layer of Spidroin by using four steel supports. The magnesium alloy (Mg) laser beam opaque inorganic target with deposited biopolymer layer of Spidroin and stainless steel 316L receiving substrate positioned opposite to Mg laser beam opaque inorganic target at 400 µm distance from the surface of biopolymer layer were fixed on CNC coordinate table. A TEA N2 laser with a wavelength of 337,1 nm, a pulse duration of 4 ns and an energy per pulse of 0,5 mJ and a repetition rate of up to 100 Hz was directed by meniscus quartz lens at the surface of magnesium alloy (Mg) laser beam opaque inorganic target. The repetition rate of the laser pulse was 1Hz and the laser energy density ranged from 100 mJ/cm² to 300 mJ/ cm² onto surface of laser beam opaque inorganic Mg target. The dimensions of laser writing nanocomposite arrays were in range from 200 µm to 350 µm. The dimensions of metal (Mg alloy) nanoparticles in biopolymer matrix (coating) were in range from 200 nm to 260 nm. The viability of the transferred arrays and patterns were verified through optical/fluorescent detection (fluorescent microscopy) (see Figure 11). The nanocomposite arrays produced in this way was examined by scanning electron microscopy (SEM, see Figure 12) and energy dispersive x-ray (EDX) spectroscopy.

## Claims

1. A method for laser assisted formation of nanocomposite materials and contactless direct deposit thereof onto a surface of a receiving substrate, comprising the steps of:
- providing one or more sources of laser energy for producing laser energy;
- providing a focusing lens;
- providing a receiving substrate, wherein the receiving substrate is positioned opposite to the source of laser energy;
- providing a laser beam opaque inorganic target, wherein the laser beam opaque inorganic target is positioned between the receiving substrate and the source of the laser energy and wherein the laser beam opaque inorganic target comprises an organic layer that is deposited on the back side of the laser beam opaque inorganic target facing the receiving substrate, said organic layer being of a material having distinct physical or chemical properties from the laser beam opaque inorganic target material;
- providing a support for holding said laser beam opaque inorganic target at a fixed distance relative to said receiving substrate;
- positioning the laser beam opaque inorganic target having the organic layer in a spaced relation to the one or more sources of laser energy so that the laser energy from said one or more sources of laser energy is directed through the focusing lens to strike the laser beam opaque inorganic target comprising the organic layer at the defined target location to perforate the laser beam opaque inorganic target at said target location and create a projection of molten droplets of inorganic material; wherein said projection passes through the organic layer and said molten inorganic droplets ablate the organic material, thereby forming a projection of hybrid nanocomposite material containing inorganic material from the laser beam opaque inorganic target and organic material from the organic layer, wherein said projection of hybrid nanocomposite material is directed to the receiving substrate and said hybrid nanocomposite material is deposited at a defined location on the receiving substrate;
- repeating the steps of positioning and striking the laser beam opaque inorganic target at successive target location, thereby exposing the laser beam opaque inorganic target at said successive defined target location to the one or more sources of laser energy such that the hybrid nanocomposite material is successively deposited at successive defined target locations of the receiving substrate.

2. The method of claim 1, wherein the method is controlled by a computer.

3. The method of claims 1 or 2, wherein said method is carried out at ambient conditions.

4. The method of any one of claims 1-3, wherein the source of laser energy is a pulsed laser.

5. The method of any one of claims 1-4, wherein the receiving substrate comprises a non-planar surface.

6. The method of any one of claims 1-5, wherein the laser beam opaque inorganic target is of any inorganic material selected from the group comprising metals, metal alloys, metal oxides, dielectrics, semiconductors.

7. The method of claims 1-6, wherein the receiving substrate is made of one or more materials selected from the group comprising chemically functionalized glass, polymer-coated glass, quartz, natural hydrogel, synthetic hydrogel, uncoated glass, nitrocellulose coated glass, silicon, glass, plastics, metals, and ceramics.

8. The method of any one of claims 1-7, wherein the organic layer comprises one or more organic or bioactive materials selected from the group comprising chemical compounds, drugs, organic polymers, dyes, peptides, proteins, recombinant proteins, DNA, portions of DNA strands, RNA, a layer of stained or fixed tissue, a layer of living tissue, and functional supporting media such as nutrients and other life supporting material.

9. Use of the method of any one of claims 1-8 for nanocoating medical devices with pharmaceutical drugs.

10. A nanocomposite material obtained by the method of anyone of claims 1-8.
